(19) Europäisches Patentamt
European Patent Office
Office européen des brevets

(11) **EP 3 857 588 B1**

(12) **EUROPÄISCHE PATENTSCHRIFT**

(45) Veröffentlichungstag und Bekanntmachung des Hinweises auf die Patenterteilung:
**11.06.2025   Patentblatt 2025/24**

(21) Anmeldenummer: **19782545.8**

(22) Anmeldetag: **30.09.2019**

(51) Internationale Patentklassifikation (IPC):
**H01J 37/244** (2006.01)     **H01J 37/28** (2006.01)

(52) Gemeinsame Patentklassifikation (CPC):
**H01J 37/244; H01J 37/28;** H01J 2237/2443;
H01J 2237/2446; H01J 2237/24495;
H01J 2237/24578; H01J 2237/2817

(86) Internationale Anmeldenummer:
**PCT/EP2019/076429**

(87) Internationale Veröffentlichungsnummer:
**WO 2020/065094 (02.04.2020 Gazette 2020/14)**

(54) **VERFAHREN ZUM BETREIBEN EINES VIELSTRAHL-TEILCHENSTRAHLMIKROSKOPS**

METHOD FOR OPERATING A MULTI-BEAM PARTICLE BEAM MICROSCOPE

PROCÉDÉ POUR FAIRE FONCTIONNER UN MICROSCOPE À FAISCEAU DE PARTICULES À FAISCEAUX MULTIPLES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.09.2018   DE 102018124044**

(43) Veröffentlichungstag der Anmeldung:
**04.08.2021   Patentblatt 2021/31**

(73) Patentinhaber: **Carl Zeiss MultiSEM GmbH**
**73447 Oberkochen (DE)**

(72) Erfinder:
• **ZEIDLER, Dirk**
**73447 Oberkochen (DE)**
• **DELLEMANN, Gregor**
**73431 Aalen (DE)**
• **SCHEUNERT, Gunther**
**89520 Heidenheim (DE)**

(74) Vertreter: **Diehl & Partner**
**Patent- und Rechtsanwaltskanzlei mbB**
**Erika-Mann-Straße 9**
**80636 München (DE)**

(56) Entgegenhaltungen:
WO-A1-2018/172186     US-A1- 2015 083 911
US-A1- 2019 355 544

**Beschreibung**

Die Erfindung betrifft Verfahren zum Betreiben von Vielstrahl-Teilchenstrahlmikroskopen.

Aus US 2015/0083911 A1 ist ein Vielstrahl-Teilchenstrahlmikroskop bekannt, bei welchem eine Vielzahl von Teilchenstrahlen auf ein Objekt gerichtet und dort fokussiert wird, so dass dort ein Feld von Auftrefforten mit den Teilchenstrahlen beleuchtet wird. Die Teilchenstrahlen erzeugen Sekundärelektronen, welche sich von den Auftrefforten von dem Objekt entfernen. Ein Projektionssystem ist dazu vorgesehen, die Sekundärelektronen zu sammeln und einem Detektionssystem zuzuführen. Hierbei werden Sekundärelektronen, welche von einem jeden Auftreffort ausgehen, zu jeweils einem Elektronenstrahl geformt, welcher genau einem Detektorelement des Detektionssystems zugeführt wird. Detektionssignale dieses Detektorelements können somit einem der Elektronenstrahlen und damit einem der Vielzahl von Auftrefforten der Teilchenstrahlen an dem Objekt zugeordnet werden. Zum Aufnehmen eines teilchenmikroskopischen Bildes wird die Vielzahl von Teilchenstrahlen parallel über die Oberfläche des Objekts gerastert bzw. gescannt, so dass ein jeder der Teilchenstrahlen eine Vielzahl von Auftrefforten beleuchtet. Die hierbei detektierten Detektionssignale können über die jeweiligen Scanposition somit der Vielzahl von Auftrefforten der Vielzahl von Teilchenstrahlen zugeordnet werden, um die ortsaufgelösten Bilddaten des teilchenmikroskopischen Bildes zu erzeugen.

WO 2018/172186 A1 offenbart ein Vielstrahl-Teilchenstrahlmikroskop mit zwei Detektionssystemen für von dem Objekt ausgehende Teilchenstrahlen.

Es hat sich gezeigt, dass die derart erzeugten teilchenmikroskopischen Bilder in manchen Einsatzsituationen unerwartete Unschärfen und Artefakte zeigen.

Entsprechend ist es eine Aufgabe der vorliegenden Erfindung, ein Vielstrahl-Teilchenstrahlmikroskop und ein Verfahren zum Betreiben desselben vorzuschlagen, mit welchen in manchen Einsatzsituationen schärfere Bilder erzeugt werden können.

Diese Aufgabe wird gelöst durch die Bereitstellung eines Verfahrens zum Betreiben eines Vielstrahl-Teilchenstrahlmikroskops mit den Merkmalen des beiliegenden Anspruchs 1 und eines Vielstrahl-Teilchenstrahlsystem mit den Merkmalen des beiliegenden Anspruchs 13.

Vorteilhafte Ausführungsformen sind in den beiliegenden abhängigen Ansprüchen 2 bis 12 und 14 angegeben.

Erfindungsgemäß umfasst ein Vielstrahl-Teilchenstrahlmikroskop einen Elektronenkonverter, ein Beleuchtungssystem, welches dazu konfiguriert ist, ein Feld von Auftrefforten an einem Objekt mit einer Vielzahl von Teilchenstrahlen zu beleuchten, und ein Projektionssystem, welches dazu konfiguriert ist, von den Auftrefforten ausgehende Elektronenstrahlen auf den Elektronenkonverter zu richten. Der Elektronenkonverter ist dazu konfiguriert, die Energie der Elektronen der Elektronenstrahlen, welche auf den Elektronenkonverter gerichtet sind, in Signale umzuwandeln, welche nachfolgend detektiert werden. Die Signale, in die die Energie der Elektronen umgewandelt wird, können Signale jeder direkt oder indirekt detektierbaren Art sein. Beispielsweise kann der Elektronenkonverter ein Szintillatormaterial umfassen, welches Energie der Elektronenstrahlen in Photonen umwandelt, welche nachfolgend detektiert werden. Hierbei kann die Detektion der Photonen wiederum indirekt erfolgen, indem die Photonen in einem HalbleiterMaterial Elektron-Loch-Paare erzeugen, die wiederum zu Spannungssignalen führen, welche in digitale Signale umgewandelt werden und die detektierten Signale repräsentieren. Geeignete Halbleiter-Elemente hierfür sind beispielsweise Avalanche-Photodioden. Ferner kann die Detektion der Photonen dadurch erfolgen, dass diese beispielsweise über Lichtleiter zu einem Elektronenmultiplier geleitet werden, welcher die Photonen mit hoher Effizienz in Spannungssignale umwandelt. Der Elektronenkonverter kann ferner beispielsweise ein Halbleitermaterial umfassen, in das die Elektronen, die auf den Elektronenkonverter gerichtet sind, eindringen und Elektron-Loch-Paare als unmittelbare Signale erzeugen, welche wiederum Spannungssignale erzeugen.

Erfindungsgemäß umfasst das Vielstrahl-Teilchenstrahlsystem ein erstes Detektionssystem mit einer Mehrzahl von Detektionselementen, welche dazu konfiguriert sind, in dem Elektronenkonverter durch auftreffende Elektronen erzeugte erste Signale zu detektieren, und ein zweites Detektionssystem mit einer Mehrzahl von Detektionselementen, welche dazu konfiguriert sind, in dem Elektronenkonverter durch auftreffende Elektronen erzeugte zweite Signale zu detektieren. Ein Detektionselement ist eine Baugruppe des Detektionssystems, welche dazu konfiguriert ist, die Signale derart zu detektieren, dass das entsprechende Detektionsergebnis dem Detektionselement zuordenbar ist. So kann beispielsweise basierend auf den Detektionsergebnissen zweier verschiedener Detektionselemente entschieden werden, ob das die Detektionsergebnisse auslösende Signal von dem einen oder dem anderen Detektionselement detektiert wurde. Es ist allerdings beispielsweise nicht möglich, anhand eines Detektionsergebnisses eines einzigen Detektionselements festzustellen, an welcher Stelle innerhalb eines Detektionsvolumens des Detektionselements das Signal detektiert wurde. Gemäß beispielhaften Ausführungsformen umfasst das erste und/oder das zweite Detektionssystem einen CCD-Detektor, und die Pixel des CCD-Detektors sind die Detektionselemente.

Gemäß beispielhaften Ausführungsformen unterscheiden sich das erste und das zweite Detektionssystem hinsichtlich einer Rate mit der die jeweiligen Detektionselemente die Signale detektieren, und/oder hinsichtlich der Anzahl der Detektionselemente des jeweiligen Detektionssystems.

Gemäß beispielhaften Ausführungsformen umfasst das erste und/oder das zweite Detektionssystem einen Lichtdetektor, welcher ein Feld von Detektorelementen aufweist, die dazu konfiguriert sind, in dem Elektronenkonverter durch auftreffende Elektronen erzeugte Signale zu detektieren, wobei die Signale Photonen sind. Das Detektionssystem kann dann ferner ein optisches Abbildungssystem umfassen, welches dazu konfiguriert ist, eine Fläche des Elektronenkonverters optisch auf das Feld von Detektionselementen des Detektionssystems abzubilden.

Das Projektionssystem kann insbesondere dazu konfiguriert sein, die Oberfläche des Objekts und damit die Vielzahl von Auftrefforten der Teilchenstrahlen an dem Objekt auf die Fläche des Elektronenkonverters abzubilden.

Über die optische Abbildung des optischen Abbildungssystems von der Fläche des Elektronenkonverters auf das Feld von Detektorelementen des Lichtdetektors entsteht an dem Feld der Detektorelemente des Lichtdetektors ein Bild der Auftrefforte der Vielzahl von Teilchenstrahlen an dem Objekt.

Gemäß beispielhaften Ausführungsformen umfassen die Detektorelemente des ersten Detektionssystems Photomultiplier. Ein Photomultiplier besteht beispielsweise aus einer Fotokathode und einem nachgeschalteten Sekundärelektronenvervielfacher. Photomultiplier sind dazu geeignet, Lichtsignale mit einer hohen Nachweiswahrscheinlichkeit und hoher Zeitauflösung zu detektieren. Andererseits sind Photomultiplier teure Geräte, welche signifikanten Bauraum einnehmen, so dass die Anzahl der Detektorelemente des ersten Detektionssystems und damit dessen Ortsauflösung in der Praxis begrenzt ist, wenn die Detektorelemente des ersten Detektionssystems Photomultiplier sind.

Gemäß beispielhaften Ausführungsformen umfassen die Detektorelemente des zweiten Detektionssystems Fotodioden. Mittels lithographischer Verfahren ist es möglich, Felder von Fotodioden herzustellen, welche eine hohe Dichte an Detektorelementen bereitstellen und damit eine hohe Ortsauflösung bieten. Beispiele für derartige Detektionssysteme sind CCD-Sensoren mit vielen einhunderttausend Detektorelementen bzw. Pixeln. Allerdings haben derartige Detektionssysteme den Nachteil, dass sie mit einer relativ geringen Rate und damit vergleichsweise langsam auslesbar sind, weshalb die Detektion der von dem Elektronenkonverter erzeugten Lichtsignale alleine durch einen CCD-Sensor bei Vielstrahl-Teilchenstrahlmikroskopen in der Praxis im Allgemeinen nicht verwendet wird.

Bei einem herkömmlichen Vielstrahl-Teilchenstrahlmikroskop weist ein Detektionssystem, welches Photomultiplier als Detektorelemente umfasst, eine Anzahl an Detektorelementen auf, welche gleich der Anzahl der Teilchenstrahlen ist, welche von dem Beleuchtungssystem auf das Objekt gerichtet werden. Dort ist jeder dieser Teilchenstrahlen genau einem Detektorelement des Detektionssystems zugeordnet, und jedem Detektorelement des Detektionssystems ist genau ein Teilchenstrahl zugeordnet. Die Detektionssignale eines jeden gegebenen Detektorelements des Detektionssystems werden dann dem Teilchenstrahl zugeordnet, der dem gegebenen Detektorelement zugeordnet ist, und die Detektionssignale werden dann weiter dem Auftreffort dieses Teilchenstrahls an dem Objekt zugeordnet, auf welchen der Teilchenstrahl während des Scannens über die Oberfläche des Objekts gerichtet war, als die Sekundärelektronen erzeugt wurden, welche die Detektionssignale ausgelöst haben.

Dieses herkömmliche Detektionsprinzip geht davon aus, dass das Projektionssystem und das optische Abbildungssystem gemeinsam dazu in der Lage sind, dass Sekundärelektronen, welche von einem gegebenen auf das Objekt treffenden Teilchenstrahl erzeugt werden, zu Detektionssignalen im Wesentlichen desjenigen Detektorelements führen, welches dem gegebenen Teilchenstrahl zugeordnet ist, während die von dem Auftreffort des gegebenen Teilchenstrahls ausgehenden Sekundärelektronen nicht zu Detektionssignalen anderer Detektorelemente des Detektionssystems führen.

Die Erfinder haben erkannt, dass diese Annahme in der Praxis nicht immer gerechtfertigt ist und in manchen Fällen Sekundärelektronen, welche von einem gegebenen Teilchenstrahl an dem Objekt ausgelöst werden, auch zu erhöhten Detektionssignalen von Detektorelementen des Lichtdetektors führen, welche verschieden sind von dem Detektorelement, welches dem gegebenen Teilchenstrahl zugeordnet ist. Dieser Effekt kann als "crosstalk" bezeichnet werden.

Gemäß beispielhaften Ausführungsformen der Erfindung werden Detektionssignale der Detektorelemente des zweiten Detektionssystems dazu verwendet, um Detektionssignale der Detektorelemente des ersten Detektionssystems Teilchenstrahlen zuzuordnen, welche auf das Objekt treffen. Insbesondere werden die Detektionssignale der Detektorelemente des zweiten Detektionssystems dazu verwendet, Detektionssignale des ersten Detektionssystems Auftrefforten der Teilchenstrahlen an dem Objekt zuzuordnen.

Gemäß beispielhaften Ausführungsformen der Erfindung umfasst ein Verfahren zum Betreiben eines Vielstrahl-Teilchenstrahlmikroskops, wie es beispielsweise vorangehend erläutert wurde, ein Scannen einer Vielzahl von Teilchenstrahlen über ein Objekt, um ein Feld von Auftrefforten der Teilchenstrahlen an dem Objekt zu beleuchten und zu verlagern, und ein Richten von von Auftrefforten der Teilchenstrahlen an dem Objekt ausgehenden Elektronenstrahlen auf einen Elektronenkonverter. Das Verfahren umfasst ferner ein Detektieren von in dem Elektronenkonverter durch auftreffende Elektronen erzeugten ersten Signalen mit einer Mehrzahl von Detektionselementen eines ersten Detektionssystems während eines ersten Zeitraums, ein Detektieren von in dem Elektronenkonverter durch auftreffende Elektronen erzeugten zweiten Signalen mit einer Mehrzahl von Detektionselementen eines zweiten Detektionssystems während eines zweiten Zeitraums, und ein Zuordnen der Signale, welche während des ersten Zeitraums mit den Detektionselementen des ersten Detektionssystems detektiert wurden, zu den Auftrefforten, und zwar basierend auf den Detektionssignalen, welche während des zweiten Zeitraums mit den Detektionselementen des zweiten Detektionssystems detektiert werden.

Gemäß beispielhaften Ausführungsformen erfolgt das Detektieren der ersten Signale mit den Detektionselementen des ersten Detektionssystems mit einer Rate, die größer ist als eine Grenzfrequenz, und das Detektieren der zweiten Signale mit den Detektionselementen des zweiten Detektionssystems erfolgt mit einer Rate, die kleiner ist ein 0,5-faches dieser Grenzfrequenz. Dies bedeutet, dass die Detektionselemente des zweiten Detektionssystems wesentlich langsamer auslesbar sind als die Detektionselemente des ersten Detektionssystems.

Gemäß beispielhaften Ausführungsformen ist eine Anzahl der Detektionselemente des zweiten Detektionssystems mehr als doppelt so groß wie eine Anzahl der Detektionselemente des ersten Detektionssystems. Dies bedeutet, dass das zweite Detektionssystem eine wesentlich höhere Ortsauflösung erreichen kann als das erste Detektionssystem.

Gemäß beispielhaften Ausführungsformen ist das Projektionssystem dazu konfiguriert, die Auftrefforte der Teilchenstrahlen an dem Objekt mittels der von dem Objekt ausgehenden Elektronenstrahlen auf eine Fläche des Elektronenkonverters abzubilden. Während die auf das Objekt auftreffenden Teilchenstrahlen an dem Objekt sehr gut fokussiert werden können und an dem Objekt kleine Strahlfoki erzeugen, ist es in der Praxis nicht möglich, diese kleinen Strahlfoki mithilfe des Projektionssystems auf sehr kleine Strahlfoki der Elektronenstrahlen an der Fläche des Elektronenkonverters abzubilden. Dies liegt daran, dass die die Elektronenstrahlen bildenden Elektronen mit einem breiten Energiespektrum aus dem Objekt austreten, so dass die durch das Projektionssystem bereitgestellte Abbildung der Elektronen von dem Objekt auf die Fläche des Elektronenkonverters bereits aufgrund der Energiebreite der Elektronen fehlerbehaftet ist. Die von einem Auftreffort an dem Objekt ausgehenden Elektronen treffen somit auf einen ausgedehnten Bereich an der Fläche des Elektronenkonverters. Allerdings ist es möglich, das Projektionssystem so auszubilden, dass Elektronen, welche von einander benachbarten Auftrefforten verschiedener Teilchenstrahlen an dem Objekt ausgehen, an der Fläche des Elektronenkonverters zwar jeweils ausgedehnte Bereiche beleuchten, voneinander verschiedene dieser ausgedehnten Bereiche allerdings nicht oder nur geringfügig überlappen. Beim herkömmlichen Vielstrahl-Teilchenstrahlmikroskop wurde angenommen, dass diese Bereiche nicht miteinander überlappen und die optische Abbildung des optischen Abbildungssystems dann diese Bereiche auf das Feld von Detektorelementen des ersten Detektionssystems abbildet.

Die Erfinder haben erkannt, dass die einander benachbarten Bereiche an der Fläche des Elektronenkonverters, auf die Elektronen der Elektronenstrahlen treffen, die von einander benachbarten Auftrefforten an dem Objekt ausgehen, sich zeitlich ändern können und insbesondere während der Dauer einer Aufnahme eines teilchenmikroskopischen Bildes durch das Scannen der Vielzahl von Teilchenstrahlen über das Objekt sich ändern können.

Mithilfe der Auswertung der Detektionssignale der Detektorelemente des zweiten Detektionssystems, welches eine höhere Ortsauflösung haben kann als das erste Detektionssystem, ist es möglich, die Art der Überlappung dieser von den Elektronenstrahlen an der Fläche des Elektronenkonverters beleuchteten Bereiche zu erfassen. Diese Erfassung kann eine Bildanalyse von mit dem zweiten Detektionssystem detektierten Bildern umfassen.

Gemäß beispielhaften Ausführungsformen werden Detektionssignale, welche während des ersten Zeitraums mit einem gegebenen Detektorelement der Detektorelemente des ersten Detektionssystems detektiert werden, wenigstens zwei verschiedenen Auftrefforten zugeordnet. Im Unterschied zum herkömmlichen Verfahren, bei dem die von einem gegebenen Detektionselement des ersten Detektionssystems detektierten Lichtsignale fälschlicherweise immer nur dem Teilchenstrahl zugeordnet werden, welcher dem gegebenen Detektorelement zugeordnet ist, erlaubt es das Verfahren gemäß der hier beschriebenen Ausführungsformen, eine flexiblere Zuordnung der Detektionssignale zu treffen, die der momentanen Situation und den eventuellen gegebenen momentanen Unzulänglichkeiten der durch das Projektionssystem bereitgestellten Abbildung Rechnung trägt. Beispielsweise kann es sich basierend auf der Auswertung der Detektionssignale der Detektorelemente des zweiten Detektionssystems ergeben, dass beispielsweise 90% der Detektionssignale eines gegebenen Detektorelements des ersten Detektionssystems dem Teilchenstrahl zugeordnet werden, der dem gegebenen Detektorelement zugeordnet ist, während 10% der Detektionssignale einem bestimmten Teilchenstrahl zugeordnet werden, der benachbart zu dem Teilchenstrahl auf das Objekt trifft, der dem gegebenen Detektorelement zugeordnet ist. Diese in gewisser Hinsicht korrektere Zuordnung von Detektionssignalen zu Teilchenstrahlen und damit zu Auftrefforten an dem Objekt kann dazu verwendet werden, teilchenmikroskopische Bilder mit vergleichsweise besseren Bildeigenschaften zu erzeugen.

Die Erfinder haben erkannt, dass das hier beschriebene Verfahren insbesondere dann vorteilhaft sein kann, wenn an dem untersuchten Objekt Oberflächenladungen vorhanden sind, welche über die Oberfläche inhomogen verteilt sind. Dies ist insbesondere dann der Fall, wenn die Ausdehnungen der Oberflächenladungen und der Wirkreichweite dieser Oberflächenladungen kleiner oder viel kleiner als die Ausdehnung des durch die Gesamtheit der Teilchenstrahlen abgebildeten Bereichs an dem Objekt ist. Oberflächenladungen an dem Objekt können insbesondere durch die das Objekt abscannenden Teilchenstrahlen selbst erzeugt werden, weshalb sich die Konfiguration der Oberflächenladungen an dem Objekt zeitlich ändern kann. Lokal vorhandene Oberflächenladungen können dazu führen, dass ein oder mehrere Elektronenstrahlen, welche von den Auftrefforten der Teilchenstrahlen an dem Objekt ausgehen, in bestimmte, durchaus verschiedene Richtungen abgelenkt werden, während andere der Elektronenstrahlen aufgrund der mit dem Abstand von den Oberflächenladungen abnehmenden Wirkungen derselben nicht oder anders abgelenkt werden. Dies führt dazu, dass sich die Konfiguration eines Bereichs, den ein gegebener Elektronenstrahl an der Fläche des Elektronenkonverters beleuchtet, hinsichtlich Gestalt und Größe zeitlich ändern kann. Es ist jedoch möglich, diese zeitliche Änderung der Konfiguration der beleuchteten Bereiche an dem Elektronenkonverter, welche wiederum durch das optische Abbildungssystem auf die Detektorelemente des ersten Detektionssystems abgebildet werden, durch die Auswertung der Detektionssignale des zweiten Detektionssystems zu erfassen und bei der Zuordnung der Detektionssignale der Detektorelemente des ersten Detektionssystems zu den Teilchenstrahlen und damit zu den Auftrefforten zu berücksichtigen.

Gemäß beispielhaften Ausführungsformen wird das Detektieren von Detektionssignalen mit den Detektionselementen des ersten Detektionssystems während mehrerer erster Zeiträume wiederholt, wobei die in einem der mehreren ersten Zeiträumen von einem gegebenen Detektionselement des ersten Detektionssystems detektierten Detektionssignale wenigstens teilweise einem gegebenen Teilchenstrahl zugeordnet werden, und wobei die in einem anderen der mehreren ersten Zeiträumen von dem gegebenen Detektionselement des ersten Detektionssystems detektierten Detektionssignale zu keinem Teil dem gegebenen Auftreffort zugeordnet werden. Dies bedeutet, dass die Zuordnung von Detektorelementen und deren Detektionssignalen zu Teilchenstrahlen sich beispielsweise während einer Aufnahme eines teilchenmikroskopischen Bildes ändern kann. Diese Änderung der Zuordnung erfolgt basierend auf den sich während dieser Zeit sich ebenfalls ändernden Detektionssignalen, welche mit den Detektionselementen des zweiten Detektionssystems detektiert werden.

Die Anzahl der Detektionselemente des ersten Detektionssystems kann gleich der Anzahl der Teilchenstrahlen sein, die über das Objekt gescannt werden. Die Anzahl der Detektionselemente des ersten Detektionssystems kann allerdings auch größer als die Anzahl der Teilchenstrahlen sein, die über das Objekt gescannt werden. Insbesondere kann die Anzahl der Detektionselemente des ersten Detektionssystems gleich einem ganzzahligen Vielfachen der Anzahl der Teilchenstrahlen sein, die über das Objekt gescannt werden. Beispielsweise kann die Anzahl der Detektionselemente des ersten Detektionssystems gleich einem Vier-Fachen oder einem 16-Fachen der Anzahl der Teilchenstrahlen sein.

Ausführungsformen der Erfindung werden nachfolgend anhand von Figuren näher erläutert. Hierbei zeigt:

Figur 1 eine schematische Darstellung eines Vielstrahl-Teilchenstrahlmikroskops;

Figur 2 eine schematische Darstellung eines Elektronendetektors des in Figur 1 gezeigten Vielstrahl-Teilchenstrahlmikroskops;

Figur 3 eine schematische Darstellung eines ersten Detektionssystems des in Figur 2 gezeigten Elektronendetektors;

Figur 4 eine schematische Darstellung eines Feldes von Detektorelementen des in Figur 3 gezeigten ersten Detektionssystems;

Figur 5 eine schematische Darstellung einer Draufsicht auf ein Feld von Detektorelementen eines zweiten Detektionssystems des in Figur 2 gezeigten Elektronendetektors;

Figur 6 eine vergrößerte teilweise Darstellung des Feldes von Detektorelementen der Figur 4 zur Erläuterung eines Verfahrens gemäß einer Ausführungsform;

Figur 7 ein Blockdiagramm zur Erläuterung des anhand der Figur 6 erläuterten Verfahrens;

Figur 8 eine Darstellung von Scanpfaden des anhand der Figuren 6 und 7 erläuterten Verfahrens;

Figur 9 ein weiteres Blockdiagramm zur Erläuterung des anhand der Figuren 6 bis 8 erläuterten Verfahrens; und

Figur 10 eine schematische Darstellung eines Elektronendetektors, der in dem in Figur 1 gezeigten Vielstrahl-Teilchenstrahlmikroskop einsetzbar ist.

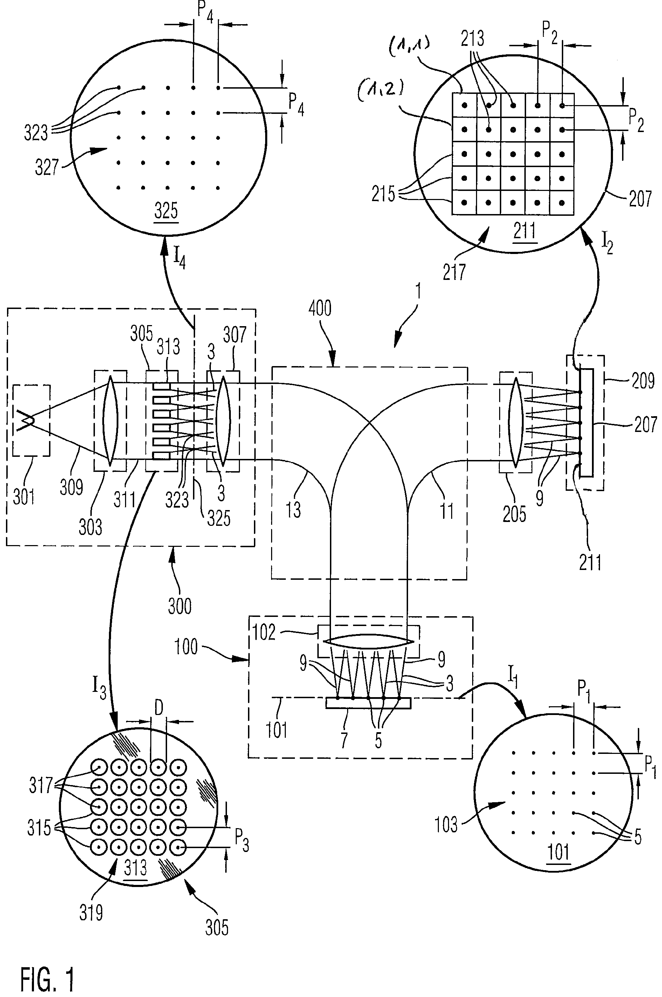

Figur 1 ist eine schematische Darstellung eines Vielstrahl-Teilchenstrahlmikroskops, welches eine Vielzahl von Strahlen geladener Teilchen einsetzt. Das Vielstrahl-Teilchenstrahlmikroskop erzeugt eine Vielzahl von Strahlen geladener Teilchen, welche auf ein zu untersuchendes Objekt treffen, um dort Sekundärelektronen zu erzeugen, welche von dem Objekt ausgehen und nachfolgend detektiert werden. Das Vielstrahl-Teilchenstrahlmikroskop 1 ist vom Rasterelektronenmikroskoptyp ("scanning electron microscope", SEM), welches eine Vielzahl primärer Elektronenstrahlen 3 einsetzt, um auf einer Oberfläche des Objekts 7 eine Vielzahl von Elektronenstrahlflecken bzw. -spots 5 zu erzeugen. Das zu untersuchende Objekt 7 kann von einer beliebigen Art sein und beispielsweise einen Halbleiter-Wafer, eine biologische Probe und eine Anordnung miniaturisierter Elemente oder dergleichen umfassen. Die Oberfläche des Objekts 7 ist in einer Objektebene 101 einer Objektivlinse 102 eines Objektivlinsensystems 100 angeordnet.

Der vergrößerte Ausschnitt I1 der Figur 1 zeigt eine Draufsicht auf die Oberfläche 101 des Objekts 7 mit einem regelmäßigen rechtwinkligen Feld 103 von Auftrefforten 5 der Teilchenstrahlen 3 auf der Oberfläche 101 des Objekts 7. In Figur 1 beträgt die Zahl der Auftrefforte 25, welche als ein 5x5-Feld 103 angeordnet sind. Die Zahl 25 an Teilchenstrahlen 3 bzw. Auftrefforten ist eine aus Gründen der vereinfachten Darstellung gewählte kleine Zahl. In der Praxis kann die Zahl an Strahlflecken wesentlich größer gewählt werden, wie beispielsweise 20x30, 100x100 und dergleichen.

In der dargestellten Ausführungsform ist das Feld 103 von Auftrefforten 5 ein im Wesentlichen regelmäßiges rechtwinkliges Feld mit einem konstanten Abstand P1 zwischen benachbarten Auftrefforten 5. Beispielhafte Werte des Abstands P1 sind 1 $\mu$m und 10 $\mu$m. Es ist jedoch auch möglich, dass das Feld 103 andere Symmetrien aufweist, wie beispielsweise eine hexagonale Symmetrie.

An den Auftrefforten 5 können Teilchenstrahlen 3 sehr fein fokussiert sein. Durchmesser der an der Oberfläche des Objekts gebildeten Strahlfoki können beispielsweise 1 nm, 5 nm, 100 nm und 200 nm betragen. Das Fokussieren der Partikelstrahlen 3 zur Formung der Strahlflecken 5 erfolgt durch das Objektivlinsensystem 100.

Die auf das Objekt treffenden Teilchen der Teilchenstrahlen 3 erzeugen dort Elektronen, welche von der Oberfläche des Objekts 7 ausgehen. Die von der Oberfläche des Objekts 7 ausgehenden Elektronen werden durch elektrische Felder, welche von der Objektivlinse 102 bereitgestellt werden, beschleunigt und zu Elektronenstrahlen 9 geformt. Das Vielstrahl-Teilchenstrahlmikroskop 1 umfasst ein Projektionssystem welches durch die Objektivlinse 102 und weitere Elektronenlinsen 205 gebildet ist. Das Projektionssystem 102, 205 stellt einen Elektronenstrahlengang 11 bereit, um die Vielzahl von Elektronenstrahlen 9 einem Elektronendetektor 209 zuzuführen. Der Elektronendetektor 209 umfasst einen Elektronenkonverter 207, auf welchen die Elektronenstrahlen 9 durch das Projektionssystem 102, 205 gerichtet werden und welcher dazu konfiguriert ist, beim Auftreffen von Elektronen der Elektronenstrahlen 9 Photonen als Signale zu erzeugen. Diese Photonen werden durch Lichtdetektoren detektiert, wie dies nachfolgend beschrieben wird. Ein Material des Elektronenkonverters 207 kann ein Szintillatormaterial, wie beispielsweise das unter der Produktbezeichnung R42 von El-Mul Technologies, Israel, vertriebene Phosphor-Material, umfassen.

Der Ausschnitt I2 in Figur 1 zeigt eine Draufsicht auf eine Oberfläche 211 des Elektronenkonverters 207, auf welche die Elektronenstrahlen 9 auftreffen. Mit dem Bezugszeichen 213 sind dort Orte bezeichnet, an denen Zentren der auftreffenden Elektronenstrahlen angeordnet sind. In der in Figur 1 dargestellten idealen Situation sind die Zentren 213 in einem Feld 217 mit einem regelmäßigen Abstand P2 voneinander angeordnet. Beispielhafte Werte des Abstands P2 sind 10 $\mu$m, 100 $\mu$m und 200 $\mu$m.

Die Teilchenstrahlen 3 werden durch ein Beleuchtungssystem 300 erzeugt, welches wenigstens eine Elektronenquelle 301, wenigstens eine Kollimationslinse 303, eine Multi-Aperturanordnung 305 und eine Feldlinse 307 umfasst. Die Elektronenquelle 301 erzeugt einen divergenten Elektronenstrahl 309, welcher durch die Kollimationslinse 303 kollimiert wird, um einen Strahl 311 zu formen, welcher die Multi-Aperturanordnung 305 beleuchtet.

Der Ausschnitt I3 in Figur 1 zeigt eine Draufsicht auf die Multi-Aperturanordnung 305. Die Multi-Aperturanordnung 305 umfasst eine Multi-Aperturplatte 313, welche eine Mehrzahl von darin ausgebildeten Öffnungen bzw. Aperturen 315 aufweist. Mittelpunkte 317 der Öffnungen 315 sind in einem Muster 319 angeordnet, welches dem Muster 103 entspricht, welches durch die Auftrefforte 5 der Teilchenstrahlen 3 an dem Objekt 7 gebildet wird. Ein Abstand P3 der Mittelpunkte 317 der Aperturen 315 voneinander kann beispielhafte Werte von 5 $\mu$m, 100 $\mu$m und 200 $\mu$m aufweisen. Die Durchmesser D der Aperturen 315 sind kleiner als der Abstand P3 der Mittelpunkte der Aperturen. Beispielhafte Werte der Durchmesser D sind 0,2 x P3, 0,4 x P3 und 0,8 x P3.

Elektronen des beleuchtenden Strahls 311 durchsetzen die Aperturen 315 und bilden Elektronenstrahlen 3. Elektronen des beleuchtenden Strahls 311, welche auf die Platte 313 treffen, werden durch diese abgefangen und tragen nicht zur Bildung der Elektronenstrahlen 3 bei.

Die Multi-Aperturanordnung 305 fokussiert die Elektronenstrahlen 3 derart, dass in einer Ebene 325 Strahlfoki 323 gebildet werden. Der Ausschnitt I4 in Figur 1 zeigt eine Draufsicht auf die Ebene 325 mit den in einem Muster 327 angeordneten Foki 323. Ein Abstand P4 der Foki 323 des Musters 327 kann gleich dem Abstand P3 in dem Muster 319 der Multi-Aperturplatte 313 sein oder von diesem verschieden sein. Ein Durchmesser der Foki 323 kann beispielsweise 10 nm, 100 nm und 1 $\mu$m betragen.

Die Feldlinse 307 und die Objektivlinse 102 stellen ein abbildendes System bereit, um die Ebene 325, in der die Foki 323 gebildet werden, auf die Objektebene 101 abzubilden, so dass dort ein Feld 103 von Auftrefforten 5 an der Oberfläche des Objekts 7 gebildet wird.

Eine Strahlweiche 400 ist in dem Strahlengang zwischen der Multi-Aperturanordnung 305 und dem Objektivlinsensystem 100 vorgesehen. Die Strahlweiche 400 ist auch Teil des Strahlengangs 11 zwischen dem Objektivlinsensystem 100 und dem Elektronendetektor 209.

Weitergehende Information zu solchen Vielstrahl-Inspektionssystemen und darin eingesetzten Komponenten, wie etwa Teilchenquellen, Multi-Aperturplatten und Linsen, kann aus den Patentanmeldungen WO 2005/024881 A2, WO 2007/028595 A2, WO 2007/028596 A1, WO 2007/060017 A2, US 2015/0083911 A1 und WO 2016/124648 A1 erhalten werden.

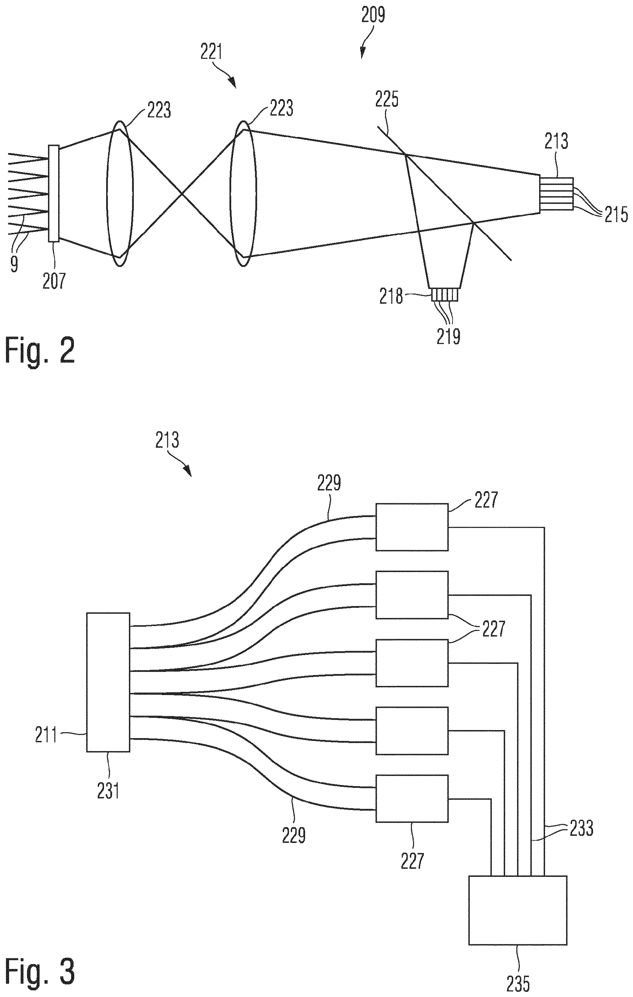

Figur 2 zeigt weitere Details des Elektronendetektors 209. Der Elektronendetektor 209 umfasst neben dem Elektronenkonverter 207 ein erstes Detektionssystem 213 mit einem Feld von Detektorelementen 215, ein zweites Detektionssystem 218 mit einem Feld von Detektorelementen 219. Das erste Detektionssystem 213 umfasst einen Lichtdetektor, und das zweite Detektionssystem umfasst in der dargestellten Ausführungsform ebenfalls einen Lichtdetektor. Ein optisches Abbildungssystem 221 ist dazu konfiguriert, die Oberfläche 211 des Elektronenkonverters 207 sowohl auf das Feld von Detektorelementen 215 des ersten Detektionssystems 213 als auch auf das Feld von Detektorelementen 219 des zweiten Detektionssystems 218 lichtoptisch abzubilden. Das optische Abbildungssystem 221 umfasst hierzu mehrere Linsen 223 und einen Strahlteilerspiegel 225, der einen Teil des auf ihn treffenden Lichts zu dem ersten Detektionssystems 213 hindurchtreten lässt und einen anderen Teil des auf ihn treffenden Lichts hin zu dem zweiten Detektionssystems 218 reflektiert.

An dem Elektronenkonverter 207 erzeugte Photonen, welche den Strahlteilerspiegel 225 durchsetzen, bilden somit die ersten Signale, die von dem ersten Detektionssystem 213 detektiert werden, und an dem Elektronenkonverter 207 erzeugte Photonen, welche an dem den Strahlteilerspiegel 225 reflektiert werden, bilden die zweiten Signale, die von dem zweiten Detektionssystem 218 detektiert werden.

Es ist jedoch auch möglich, dass das Licht, welches auf das erste Detektionssystem 213 trifft an dem Strahlteilerspiegel 225 reflektiert wird, während das Licht, das auf das zweite Detektionssystem 218 trifft, den Strahlteilerspiegel 225 durchsetzt. Hierbei kann vorgesehen sein, dass der Strahlteilerspiegel 225 so ausgelegt ist, dass der Anteil des auf diesen treffenden Lichts, der dem ersten Detektionssystem 213 zugeführt wird, fünfmal, zehnmal oder 50 mal größer ist als der Anteil, der dem zweiten Detektionssystem 218 zugeführt wird.

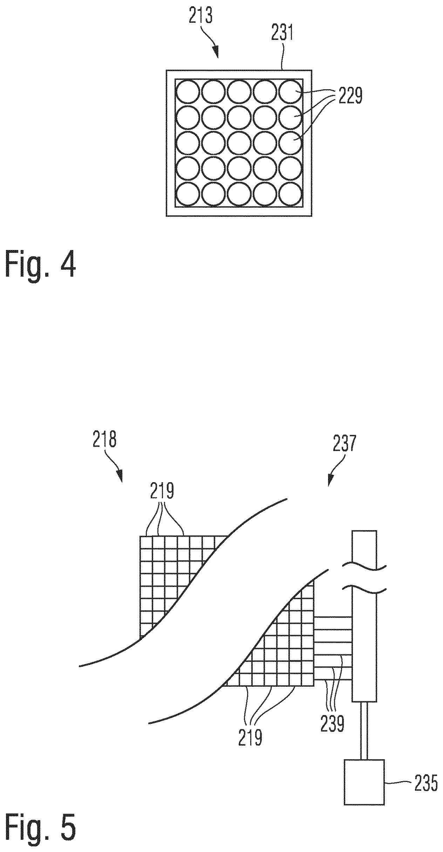

Details des ersten Detektionssystems 213 sind in Figur 3 schematisch dargestellt. Das erste Detektionssystem 213 umfasst eine Mehrzahl von Photomultipliern 227. Die Anzahl der Photomultiplier 227 kann der Anzahl der Teilchenstrahlen 3 entsprechen, sie kann aber auch größer sein. Ein jeder der Photomultiplier 227 ist an ein Ende eines Lichtleiters 229 angeschlossen, um dem Photomultiplier 227 zu detektierendes Licht zuzuführen. Die jeweils anderen Enden der Lichtleiter 229 sind in einem Rahmen 231 zusammengefasst, um die Enden der Lichtleiter 229 in einem Feld anzuordnen, dessen Geometrie der Geometrie des Feldes 217 (Figur 1, I2) entspricht, welches durch die auftreffenden Elektronenstrahlen 9 auf der Oberfläche des Elektronenkonverters 207 gebildet wird. Das Feld 217 auf der Oberfläche des Elektronenkonverters 207 wird durch das optische Abbildungssystem 221 auf das Feld von Enden der Lichtleiter 229 abgebildet. Figur 4 stellt eine Draufsicht auf das durch die in dem Rahmen 231 gehaltenen Enden der Lichtleiter 229 gebildete Feld dar.

Die Elektronen der Elektronenstrahlen 9, welche auf den Elektronenkonverter 207 auftreffen, erzeugen Photonen, von denen ein Teil in Richtung hin zu dem optischen Abbildungssystem 221 aus dem Elektronenkonverter 207 austritt. Das optische Abbildungssystem 221 verwendet diese Photonen, um die Auftrefforte 213 der Elektronenstrahlen 9 auf die Enden der Lichtleiter 229 abzubilden. Ein Teil der Photonen tritt in die Lichtleiter 229 ein und wird durch diese den Photomultipliern 227 zugeführt. Die Photomultiplier 227 wandeln die eingehenden Photonen in elektronische Signale um, welche über Signalleitungen 233 einer Steuerung 235 zugeführt werden. Die Steuerung 235 ist somit in der Lage, die Detektionssignale eines gegebenen Photomultipliers 227 zu detektieren, wobei die Intensität der detektierten Signale im Wesentlichen proportional zur Intensität eines der Elektronenstrahlen 9 ist, der dem jeweiligen Photomultiplier 227 zugeordnet ist.

Figur 5 zeigt eine Draufsicht auf die Detektorelemente 219 des zweiten Detektionssystems 218. Die Detektorelemente 219 sind durch die Fotodioden eines CCD-Sensors 237 gebildet, in dem die Fotodioden 219 in einem rechteckigen Feld angeordnet sind. Eine Zahl der Detektorelemente 219 des zweiten Detektionssystems 218 kann beispielsweise 128x128, 1024x1024 oder andere Werte betragen. Die Detektorelemente 219 des CCD-Sensors 237 werden zeilenweise über Leitungen 239 aus dem Feld von Detektorelementen 219 ausgelesen und an die Steuerung 235 übertragen.

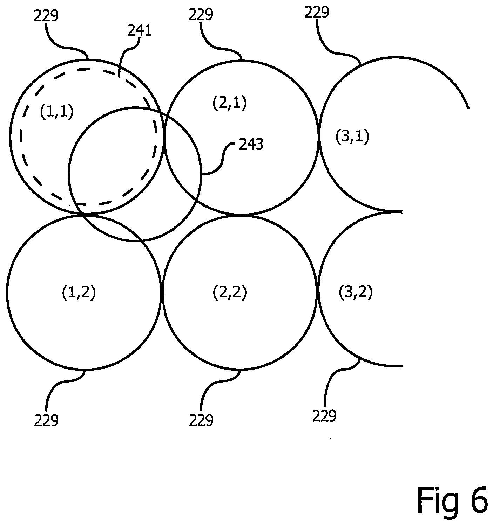

Figur 6 ist eine vergrößerte teilweise Darstellung des in Figur 4 gezeigten Feldes der Enden der Lichtleiter 229. Hierbei sind lediglich die vier Lichtleiter dargestellt, welche in Figur 4 links oben in dem Feld angeordnet sind. Diese Enden der Lichtleiter 229 können mit Feldindizes (1,1); (2,1); (1,2); und (2,2) bezeichnet werden.

Ein mit einer unterbrochenen Linie 241 dargestellter Kreis umschließt eine Fläche, innerhalb der 90% der Photonen auf das Ende des Lichtleiters 229 mit dem Feldindex (1,1) in der vorangehend als ideal geschilderten Situation treffen würden, in welcher jeder Teilchenstrahl genau einem Detektorelement des ersten Detektionssystems zugeordnet ist und jedem Detektorelement des ersten Detektionssystems genau ein Teilchenstrahl 3 zugeordnet ist. Insbesondere würde in dieser Situation der Teilchenstrahl, welcher in dem Feld 101 (vergleiche I1, Figur 1) den links oben angeordneten Auftreffort 5 beleuchtet und Sekundärelektronen erzeugt, welche zu einem Elektronenstrahl 9 geformt werden, der in dem Feld 211 (vergleiche I2, Figur 1) auf der Oberfläche 211 des Elektronenkonverters 207 das links oben angeordnete Segment beleuchtet und dort Photonen erzeugt, durch die Abbildungsoptik 221 auf das Ende des Lichtleiters (1,1) abgebildet werden. Wenn dem so ist, können alle Detektionssignale, die von dem Photomultiplier 227 detektiert werden, der an den Lichtleiter (1,1) angeschlossen ist, dem Teilchenstrahl zugeordnet werden, der in dem Feld 101 links oben angeordnet ist.

Abweichend von dieser idealen Situation treten in der Praxis Situationen auf, in denen die durch diesen einen Teilchenstrahl ausgelösten Photonen nicht zu 90% in dem Kreis 241 landen, sondern in einem versetzt hierzu angeordneten und in Figur 6 mit durchgezogener Linie dargestellten Kreis 243. Diese Verlagerung kann beispielsweise darauf zurückzuführen sein, dass an der Oberfläche des Objekts 7 elektrische Ladungen vorhanden sind, die den Strahl 9 aus Sekundärelektronen aus seiner idealen Bahn ablenken, so dass die durch diesen Strahl an dem Elektronenkonverter 207 ausgelösten Photonen zum größten Teil innerhalb des Kreises 243 landen. Dies bedeutet, dass ein Teil dieser Photonen in das Faserende (2,1) eintritt und ein weiterer Teil in das Faserende (1,2) eintritt. Bei der in der Figur 6 dargestellten Situation könnte angenommen werden, dass die Detektionssignale, welche dem erläuterten Teilchenstrahl 3 zuzurechnen sind, sich aus einer Summe von Detektionssignalen ergeben, die von verschiedenen Photomultipliern 227 detektiert werden. Für die in Figur 6 dargestellte Situation könnte sich die dem besagten Teilchenstrahl 3 zuzuordnende Intensität I an Detektionssignalen beispielsweise wie folgt ergeben:

$$I = 0,8 \text{ x } I(1,1) + 0,15 \text{ x } I(2,1) + 0,05 \text{ x } I(1,2)$$

Die Faktoren 0,8, 0,15 und 0,05 ergeben sich aus einer geometrischen Überlegung zu der Überlappung des Kreises 243 mit den Flächen der Enden der Fasern 229. Gegebenenfalls kann bei dieser Überlegung auch die inhomogene Verteilung der Intensitäten der Photonen innerhalb des Kreises berücksichtigt werden. Die Verteilung dieser Intensitäten folgt üblicherweise einer Gaußfunktion mit hohem zentralem Maximum und sich auch nach außerhalb des Kreises 243 erstreckenden Ausläufern.

Die Position des Kreises 243 kann mithilfe des ersten Detektionssystems alleine nicht bestimmt werden. Allerdings kann die Lage des Kreises 243 mithilfe des zweiten Detektionssystems 218 detektiert werden, welcher die gleiche Verteilung an Lichtintensitäten empfängt wie das erste Detektionssystem, aufgrund seiner größeren Zahl an Detektorelementen allerdings eine bessere Ortsauflösung bietet. Durch eine Bildanalyse von durch das zweite Detektionssystem 218 detektierten Bildern ist es somit möglich, für einen jeden der Teilchenstrahlen 3 einen diesem zugeordneten Kreis 243 auf der Fläche der Enden der Lichtleitfasern 229 zu ermitteln. Basierend auf der Überlappung dieser Kreise 243 mit den Enden der Lichtleiterfasern 229 ist es dann möglich, zu bestimmen, zu welchen Anteilen Detektionssignale der einzelnen Detektorelemente des ersten Detektionssystems welchen Teilchenstrahlen 3 zuzuordnen sind.

Die oben beispielhaft gewählten Faktoren sind unter der Annahme entstanden, dass die Detektorelemente (1,1), (2,1) und (1,2) keine Signale erhalten, die auf andere Teilchenstrahlen zurückgehen als den, der durch den Kreis 243 repräsentiert ist. In der Regel muss ein Gleichungssystem gelöst werden, um die korrekten Zuordnungen von Detektionssignalen zu Teilchenstrahlen zu erhalten. Die Lösung eines solchen Gleichungssystems wird vereinfacht, wenn die Anzahl der Detektionselemente des ersten Detektionssystems größer ist als die Anzahl der Teilchenstrahlen 3.

Mit dem hier erläuterten Verfahren ist es somit möglich, einem jeden der Teilchenstrahlen 3 Detektionssignale zuzuordnen, die von mehreren Detektorelementen 215 des ersten Detektionssystems 213 detektiert wurden. Dies erfolgt basierend auf einer Bildanalyse von durch den zweiten Detektionssystems 218 aufgenommenen Bildern. Dieses Verfahren führt zu Bildern mit höherem Kontrast und weniger Artefakten, da nicht sämtliche Detektionssignale, welche von einem gegebenen Detektorelement 215 des ersten Detektionssystems 213 detektiert werden, immer nur genau einem der Teilchenstrahlen 3 zugeordnet werden.

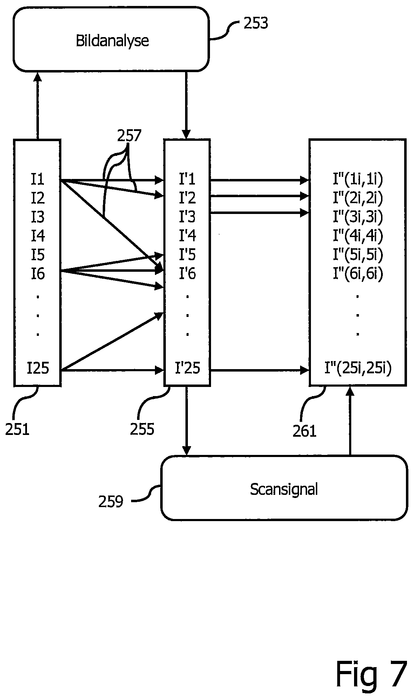

Dieses Verfahren wird nachfolgend nochmal anhand des Blockdiagramms der Figur 7 erläutert. Dort bezeichnet das Bezugszeichen 251 einen Vektor von Signalintensitäten I1, I2, ... I25, welche durch die 25 Detektorelemente 215 des ersten Detektionssystems 213 innerhalb eines ersten Zeitraums detektiert werden. Während eines zweiten Zeitraums, der zeitlich vor dem ersten Zeitraum liegen kann, der zeitlich nach dem ersten Zeitraum liegen kann, der kürzer oder länger als der erste Zeitraum sein kann und der innerhalb des ersten Zeitraums liegen kann oder den ersten Zeitraum enthalten kann, wird mit dem zweiten Detektionssystem 218 ein Bild aufgenommen, welches einer Bildanalyse 253 unterzogen wird. Basierend auf dieser Bildanalyse 253 werden die Anteile bestimmt, zu welchen die von den Detektorelementen 215 des ersten Detektionssystems 213 detektierten Detektionssignale einzelnen Teilchenstrahlen 3 zuzuordnen sind. Diese Anteile können beispielsweise als eine Matrix repräsentiert werden, mit welcher der Vektor 251 multipliziert wird, um einen Vektor 255 zu erhalten, dessen Elemente I'1, I'2, ... I'25 die den einzelnen Strahlen zugeordneten detektierten Intensitäten repräsentieren. Wie oben erwähnt, kann eine Lösung eines Gleichungssystems oder eine andere aufwändige Berechnung, wie etwa eine iterative Berechnung notwendig sein, um diese Matrix zu erhalten. In dem Fall, in dem die Anzahl der Detektorelemente des ersten Detektionssystems größer ist als die Anzahl der Teilchenstrahlen, weist der Vektor 251 eine Anzahl von Komponenten auf, die gleich der Anzahl der Detektorelemente des ersten Detektionssystems ist, während die Anzahl von Komponenten des Vektors 255 gleich der Anzahl der Teilchenstrahlen ist. Falls eine Matrix verwendet wird, um aus dem Vektor 251 den Vektor 255 zu erhalten, so wäre diese entsprechend nicht-quadratisch.

Pfeile 257 in Figur 7 repräsentieren die Tatsache, dass von einem Detektorelement detektierte Detektionssignale mehreren Strahlen zugeordnet werden. So werden beispielsweise von dem ersten Detektorelement I1 detektierte Intensitäten den Strahlen 1, 2 und 6 zugeordnet, nicht allerdings den übrigen Strahlen.

Das Verfahren beinhaltet ferner ein Scannen der Teilchenstrahlen 3 über die Oberfläche des Objekts. Hierzu kann beispielsweise die Steuerung 235 einen Scangenerator umfassen, der ein geeignetes Scansignal 259 bereitstellt. Basierend auf dem Scansignal 259 wird ein Strahlablenker mit zeitlich veränderlichen Spannungen versorgt, welcher im Bereich des Strahlengangs 13 beispielsweise in oder nahe der Objektivlinse 102 angeordnet ist, um das Bündel der Teilchenstrahlen 3 gemeinsam basierend auf dem Scansignal abzulenken, so dass die Auftrefforte 5 der Teilchenstrahlen 3 auf der Oberfläche des Objekts 7 verlagert werden.

So können beispielsweise die Auftrefforte 5 der Teilchenstrahlen 3 auf der Oberfläche des Objekts 7 schrittweise nach Ablauf eines vorgegebenen Zeitraums, der gleich dem ersten Zeitraum sein kann, zu neuen Auftrefforten 5 verlagert werden, so dass nacheinander eine sehr große Vielzahl von Auftrefforten 5 mit den Teilchenstrahlen 3 beleuchtet werden. Diesen Auftrefforten werden schließlich die detektierten Detektionssignale zugeordnet, um das teilchenmikroskopische Bild zu bilden. In Figur 7 ist ein Vektor 261 dargestellt, welcher detektierte Signalintensitäten I'' repräsentiert, die in einem derartigen Zeitschritt während eines ersten Zeitintervalls i Auftrefforten (1i,1i), (2i, 2i), ... zugeordnet werden. Die Größe i repräsentiert hierbei einen Index der nacheinander durchgeführten Zeitschritte. Die Zuordnung der den einzelnen Teilchenstrahlen 3 zugeordneten Detektionssignale des Vektors 255 zu einzelnen Auftrefforten zugeordneten Detektionssignalen des Vektors 261 erfolgt basierend auf dem Scansignal 259 des Scangenerators.

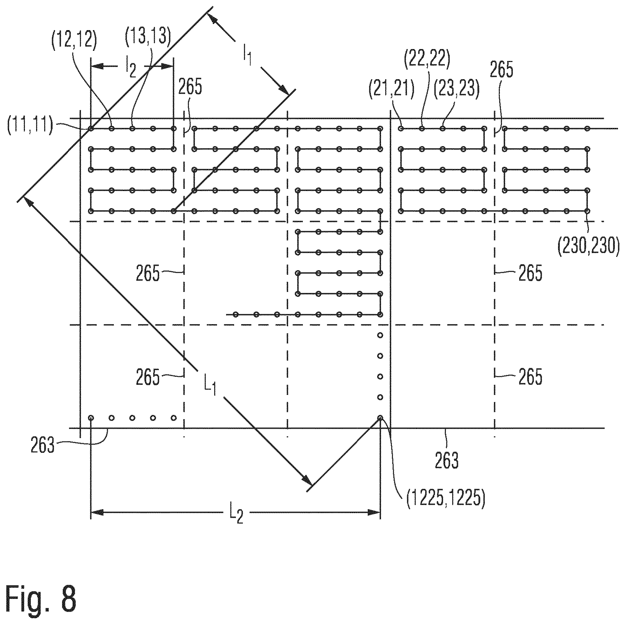

Ein Beispiel für den Betrieb des Scangenerators und der Erzeugung des Scansignals 259 wird nachfolgend anhand der Figur 8 erläutert. Diese zeigt eine Draufsicht auf die Oberfläche des Objekts 7 und Auftrefforte 5, die im Rahmen des Scannens innerhalb der durchgeführten Zeitschritte nacheinander beleuchtet werden. Die 255 Auftrefforte, welche von dem ersten Teilchenstrahl 3 nacheinander beleuchtet werden, sind mit (11,11), (12,12), ... (1225,1225) bezeichnet. Diese liegen innerhalb eines quadratischen Bereichs 263 der Oberfläche des Objekts, der 225 Auftrefforte enthält. Die durch das Scannen nacheinander erzeugten Auftrefforte sind in Figur 8 durch eine Linie miteinander verbunden, welche den Scanpfad des Teilchenstrahls repräsentiert. Es ist ersichtlich, dass der Scanpfad mäanderförmig verläuft. Insbesondere enthält der Bereich 263 der Oberfläche des Objekts 7 neun Bereiche 265, welche jeweils 25 Auftrefforte enthalten, die nacheinander in dem Scanpfad enthalten sind. Die Bereiche 265 der Oberfläche des Objekts sind wesentlich kleiner als die Bereiche 263 der Oberfläche des Objekts. Um die Verhältnisse der Größen der Bereiche 263 und 265 korrekt zu beurteilen, werden jeweils die konvexen Hüllen der in den Bereichen 263 bzw. 265 enthaltenen Auftrefforte betrachtet. Die konvexe Hülle einer Menge von Auftrefforten ist die kleinstmögliche Fläche mit konvexem Rand, die sämtliche dieser Auftrefforte enthält.

Die maximale laterale Ausdehnung der konvexen Hülle der Auftrefforte, die in dem Oberflächenbereich 265 liegen, ist in Figur 8 mit l1 bezeichnet, die minimale laterale Ausdehnung dieser Auftrefforte ist mit l2 bezeichnet, und die maximale laterale Ausdehnung der konvexen Hülle der in dem Oberflächenbereich 263 enthaltenen Auftrefforte ist in Figur 8 mit L1 bezeichnet, während die minimale laterale Ausdehnung dieser Auftrefforte mit L2 bezeichnet ist. Es ist ersichtlich, dass gilt:

$$2 \times l1 < L1$$

und

$$2 \times l2 < L2$$

Dies bedeutet, dass die Oberflächenbereiche 265 hinsichtlich ihrer lateralen Ausdehnung deutlich kleiner sind als die Oberflächenbereiche 263.

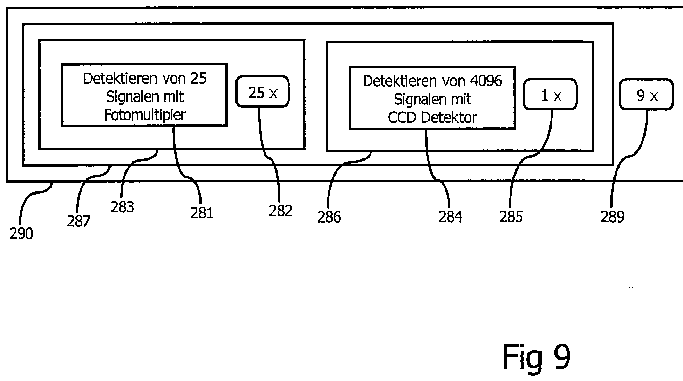

Das Scanverfahren wird nachfolgend anhand der Figur 9 nochmals erläutert. Zusammengefasst läuft das Scanverfahren wie folgt ab: Die von dem Scangenerator erzeugten Scansignale 259 werden während einer ersten Zeitdauer nicht verändert. Während der ersten Zeitdauer beleuchten die einzelnen Teilchenstrahlen 3 somit unveränderte Auftrefforte an der Oberfläche des Objekts. Es wird ein Vektor 251 aus Detektionssignalen aufgezeichnet, die während des ersten Zeitraums durch die Photomultiplier 227 detektiert werden. Diese während des ersten Zeitraums stattfindende Maßnahme ist in Figur 9 durch einen Block 281 repräsentiert. Daraufhin wird das Scansignal verändert, um die Auftrefforte der Teilchenstrahlen an dem Objekt entlang ihrer Scanpfade um eine Position zu verlagern. Dort wird die Maßnahme des Blocks 281 wiederholt. Nach 25 derartigen Wiederholungen, die in Figur 9 durch einen Block 282 repräsentiert sind, sind alle 25 Auftrefforte abgescannt, die in einem der Oberflächenbereiche 265 liegen. Diese Maßnahme des Abscannens der 25 Auftrefforte innerhalb eines der Oberflächenbereiche 265 ist in Figur 9 durch einen Block 283 repräsentiert. Die Ausführung der Maßnahmen des Blocks 283 dauert eine zweite Zeitdauer, welche etwa 25 Mal größer ist als die erste Zeitdauer.

Während der zweiten Zeitdauer wird zudem ein Bild mit den Detektorelementen 219 des zweiten Detektionssystems 218 aufgenommen. Hierbei wird angenommen, dass die Zahl der Detektorelemente 219 des zweiten Detektionssystems 4096 beträgt. Die Aufnahme eines Bildes ist in Figur 9 durch den Block 284 repräsentiert. Die Maßnahme der Aufnahme eines Bildes mit dem zweiten Detektionssystem wird innerhalb des zweiten Zeitraums einmal wiederholt, wie durch den Block 285 in Figur 9 angezeigt. Die Ausführung der einmaligen Wiederholung der Aufnahme dieses Bildes, die gleichzeitig mit den mit 283 bezeichneten Maßnahmen stattfindet, ist in Figur 9 durch einen Block 286 repräsentiert. Die Maßnahmen 283 und 286 können parallel bzw. gleichzeitig durchgeführt werden, da das erste Detektionssystem 213 und das zweite Detektionssystem 218 aufgrund des Strahlteilers 225 gleichzeitig einander entsprechende Signale detektieren können. Die gleichzeitige Ausführung der Maßnahmen 283 und 286 ist in Figur 9 durch einen Block 287 repräsentiert und beinhaltet zum einen die Detektion von Detektionssignalen, welche den innerhalb eines der Bereiche 265 angeordneten Auftrefforten zugeordnet werden und die Detektion eines Bildes mit dem zweiten Detektionssystem 218. Basierend auf dem durch das zweite Detektionssystem 218 detektierten Bild, d. h. basierend auf der anhand dieses Bildes durchgeführten Bildanalyse 253 werden alle innerhalb des zweiten Zeitraums gewonnenen 25 Vektoren 251 in 25 Vektoren 255 umgewandelt, welche jeweils die den einzelnen Teilchenstrahlen zugeordneten Detektionssignale repräsentieren.

Dies bedeutet, dass die in 25 nacheinander durchgeführten Maßnahmen 281 gewonnenen Detektionssignale gemäß der gleichen Zuordnung den einzelnen Teilchenstrahlen zugeordnet werden, wobei diese Zuordnung auf einem einzigen in der Maßnahme 284 ebenfalls während des zweiten Zeitraums gewonnenen mit dem zweiten Detektionssystem aufgenommenen Bild basiert.

Generell wäre es wünschenswert, während jedes ersten Zeitraums die Maßnahme 284 einmal durchzuführen und damit genauso viele Bilder mit dem zweiten Detektionssystem aufzunehmen, wie Maßnahmen 281 erfolgen. Allerdings ist das Aufnehmen und Auslesen von Bildern in dem dargestellten Beispiel mit dem CCD-Detektor mit der dem ersten Zeitraum entsprechenden Frequenz nicht möglich, weshalb die Maßnahme 284 nur einmal durchgeführt wird, während die Maßnahme 281 25 mal durchgeführt wird. Dafür weist der CCD-Detektor aber eine ausreichend hohe Ortsauflösung auf, um durch Bildanalyse festzustellen, welche der Detektorelemente 215 des ersten Detektionssystems 213 Detektionssignale empfangen, die einzelnen Teilchenstrahlen zuzuordnen sind.

Die Maßnahmen des Blocks 287 werden neunmal wiederholt, wie durch den Block 289 angedeutet, um nacheinander mit jedem der Teilchenstrahlen einen der neun Oberflächenbereiche 265 abzuscannen, die in dem Oberflächenbereich 263 enthalten sind. Die Gesamtheit dieser Maßnahmen ist in Figur 9 durch einen Block 290 bezeichnet und umfasst die Gewinnung von teilchenmikroskopischen Bilddaten durch 25 Teilchenstrahlen, welche jeweils auf 255 Auftrefforte gerichtet werden, so dass zu 6.375 Auftrefforten jeweils eine Intensitätsmessung durchgeführt wird.

Innerhalb des Blocks 290 beleuchtet jeder Teilchenstrahl 225 Auftrefforte, die in neun verschiedenen Objektbereichen 265 angeordnet sind, die nacheinander abgescannt werden. Während des Abscannens eines jeden der Oberflächenbereiche 265 wird mit dem zweiten Detektionssystem ein Bild aufgenommen, welches als Grundlage zur Bestimmung einer Zuordnung von Detektionssignalen, die von den einzelnen Detektionselementen des ersten Detektionssystem detektiert werden, zu den einzelnen Teilchenstrahlen ermöglicht.

Somit werden neun verschiedene Zuordnungen für 225 verschiedene nacheinander gewonnene Vektoren 251 von Detektionssignalen verwendet. Hierbei ist der Scanpfad so gewählt, dass unter der Berücksichtigung der lateralen Ausdehnung der konvexen Hülle der in dem Oberflächenbereich 263 enthaltenen Auftrefforte die konvexe Hülle der Auftrefforte, auf welche die gleiche Zuordnung angewendet wird, möglichst klein ist. Dies wird insbesondere durch die Wahl des mäanderförmigen Scanpfads ermöglicht. Dieser Wahl des Scanpfads liegt die Überlegung zu Grunde, dass Änderungen der Zuordnung von Detektionssignalen zu Teilchenstrahlen durch lokal an der Oberfläche vorhandene Oberflächenladungen hervorgerufen werden. Diese Oberflächenladungen wirken nicht gleichförmig auf alle Teilchenstrahlen sondern nur auf Teilchenstrahlen, deren Auftrefforte auf dem Objekt nahe der Oberflächenladung liegen. Ferner wird angenommen, dass sich diese Oberflächenladungen während des Scannens langsam verändern. Diese Überlegung rechtfertigt, dass für mehrere im Scanpfad nacheinander angeordnete Auftrefforte die gleiche Zuordnung von Detektionssignalen zu Teilchenstrahlen verwendet wird.

Das Scanverfahren wurde vorangehend unter Zugrundelegung vereinfachter Werte für die Anzahl 25 der eingesetzten Teilchenstrahlen, die Anzahl neun der Oberflächenbereiche 265, welche in dem von einem Teilchenstrahl abgescannten Oberflächenbereich 263 enthalten sind, und die Zahl 25 für die Anzahl der Auftrefforte, welche in einem Oberflächenbereich 265 enthalten sind, erläutert. In der Praxis können die einzelnen Zahlenwerte wesentlich größer gewählt werden.

In der Darstellung der Figur 7 erfolgt die Zuordnung von Detektionssignalen, welche von den einzelnen Detektorelementen des ersten Detektionssystems detektiert werden, zu den einzelnen Teilchenstrahlen basierend auf der Bildanalyse 253 vor der Zuordnung der den einzelnen Teilchenstrahlen zugeordneten Detektionssignale zu den einzelnen Auftrefforten basierend auf dem Scansignal 259 des Scangenerators. Diese Reihenfolge kann vertauscht werden, und es kann die Zuordnung basierend auf der Bildanalyse 253 zu einzelnen Teilchenstrahlen nach dem Zuordnen der einzelnen Teilchenstrahlen zu den Auftrefforten basierend auf dem Scansignal 259 erfolgen.

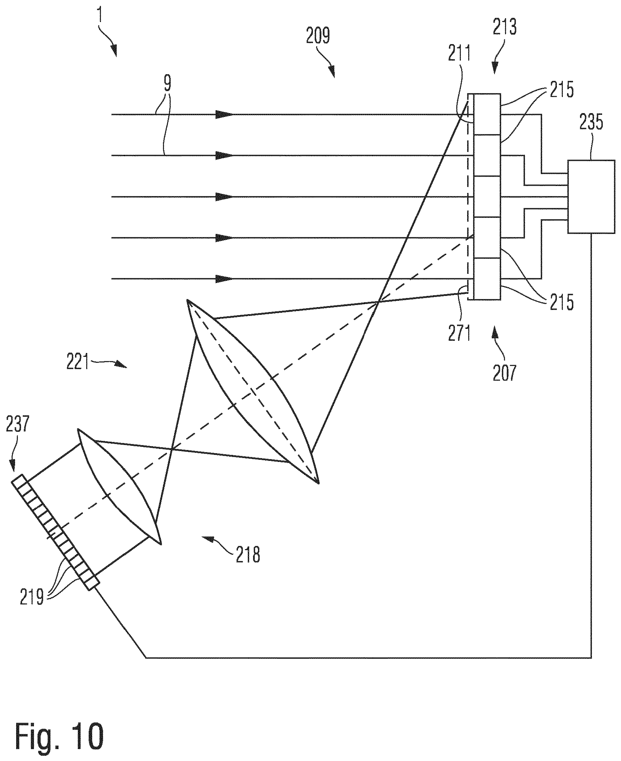

Figur 10 zeigt eine weitere Variante eines Elektronendetektors 209, welcher in dem Vielstrahl-Teilchenstrahlmikroskop der Figur 1 einsetzbar ist, in schematischer Darstellung. Der Elektronendetektor 209 weist einen Elektronenkonverter 207 auf, auf dessen Oberfläche 211 die Elektronenstrahlen 9 in der Darstellung der Figur 10 von links auftreffen.

Die Energie der Elektronen der Elektronenstrahlen 9 wird durch den Elektronenkonverter 207 in zwei verschiedene Arten von Signalen umgewandelt, welche von zwei verschiedenen Detektionssystemen detektiert werden.

Ein erstes Detektionssystem 213 der beiden Detektionssysteme umfasst Detektorelemente 215, welches Halbleiterelemente, wie beispielsweise Silizium-Drift-Detektoren und PIN-Dioden, sind. Diese sind auch Teil des Elektronenkonverters, indem in den Halbleiterelementen die in diese eindringenden Elektronen der Elektronenstrahlen 9 in erste Signale, nämlich Elektron-Loch-Paare, umgewandelt werden, welche in den Halbleiterelementen elektrische Signale auslösen, die, nach geeigneter Verstärkung, an eine Steuerung 235 des Vielstrahl-Teilchenstrahlmikroskops 1 ausgegeben werden. Die Halbleiterelemente der Detektorelemente 215 sind mit hoher Rate, wie beispielsweise 40 MHz bis 400 MHz, auslesbare Elektronendetektoren, die auftreffende Elektronen in elektrische Signale umwandeln. Die Anzahl der Detektorelemente 215 des ersten Detektionssystems 213 kann gleich oder größer sein als die Anzahl der auf den Elektronenkonverter 207 auftreffenden Elektronenstrahlen 9.

Ein zweites Detektionssystem 218 des Elektronendetektors 209 umfasst einen Lichtdetektor 237, wie beispielsweise einen CCD-Sensor, der ein Feld aus Detektorelementen bzw. Pixeln 219 aufweist. Die Zahl der Detektorelemente 219 des zweiten Detektionssystems 218 ist wesentlich größer als die Zahl der Detektorelemente 215 des ersten Detektionssystems 213.

Zwischen dem Elektronenkonverter 207 und dem Lichtdetektor 237 ist ein optisches Abbildungssystem 221 vorgesehen, welches die Oberfläche 211 des Elektronenkonverters 207 auf das Feld der Detektorelemente 219 des zweiten Detektionssystems 218 optisch abbildet.

Der Elektronenkonverter 207 ist aufgrund seiner die Halbleiterelemente 215 umfassenden Konfiguration dazu ausgebildet, einen Teil der auf ihn treffenden Elektronen der Elektronenstrahlen 9 in die ersten Signale, nämlich die Elektron-Loch-Paare, umzuwandeln, welche durch das erste Detektionssystem 213 detektiert werden. Ein weiterer Teil der auf den Elektronenkonverter 207 auftreffenden Elektronen der Elektronenstrahlen 9 wird in zweite Signale, nämlich Photonen, umgewandelt, welche von der Oberfläche 211 des Elektronenkonverters 207 austreten, auf welche auch die Elektronenstrahlen 9 auftreffen. In der Darstellung der Figur 10 treten diese Photonen aus dem Elektronenkonverter 207 nach links aus.

Ein Teil dieser an der Oberfläche 211 des Elektronenkonverters 207 austretenden Photonen wird durch das optische Abbildungssystem 221 auf den Lichtdetektor 237 abgebildet und von dessen Detektionselementen 219 detektiert. Die von dem Lichtdetektor 237 detektierten Bilder werden an die Steuerung 235 übertragen.

Die von dem zweiten Detektionssystem 218 detektierten Signale können Photonen verschiedener Art sein. Zum einen führen die auf die Oberfläche 211 des Elektronenkonverters 207 auftreffenden Elektronenstrahlen 9 dort zu einer lokalen Erwärmung. Diese lokale Erwärmung erzeugt Photonen, welche von dem Lichtdetektor 237 im infraroten Bereich des Strahlungsspektrums nachweisbar sind. Diese Photonen haben Photonenenergien von beispielsweise 1 meV bis 500 meV.

Zum Nachweis dieser Photonen sind der Lichtdetektor 237 und das optische Abbildungssystem 221 vorteilhafterweise als Infrarotkamera ausgebildet. Mit der Infrarotkamera kann somit ein Wärmebild der Oberfläche 211 des Elektronenkonverters 207 erzeugt und dann ausgewertet werden. Das Wärmebild repräsentiert die Verteilung der auf die Oberfläche 211 des Elektronenkonverters 207 auftreffenden Elektronenintensitäten. Eine Ausleserate des Lichtdetektors 237 ist wesentlich langsamer als die Ausleserate der Detektionselemente 215 des ersten Detektionssystems 213, dafür ist aber die Anzahl der Detektionselemente 219 des zweiten Detektionssystems 218 wesentlich größer als die Anzahl der Detektionselemente 215 des ersten Detektionssystems 213. Wie vorangehend bereits erläutert, kann basierend auf einer Bildanalyse der von dem Lichtdetektor 237 detektierten Bilder eine verbesserte Zuordnung der durch die Detektionselemente 215 des ersten Detektionssystems 213 detektierten Signale zu den auf den Elektronenkonverter 207 auftreffenden Elektronenstrahlen 9 und schließlich zu den Auftrefforten der Teilchenstrahlen 3 auf dem Objekt 7 erfolgen.

Alternativ zu der Ausbildung des Lichtdetektors 237 und des optischen Abbildungssystems 221 als Infrarotkamera kann auch eine im sichtbaren Bereich des Lichtspektrums oder anderen Bereichen des Lichtspektrums arbeitende Kamera eingesetzt werden, wenn an der Oberfläche 211 des Elektronenkonverter 207 eine in Figur 10 mit gestrichelten Linien dargestellte Schicht 271 aus Szintillatormaterial vorgesehen ist. Das Szintillatormaterial wandelt die Energie eines Teils der Elektronen der Elektronenstrahlen 9 in Photonen mit Energien von beispielsweise 1 eV bis 4 eV um, welche damit größer sind als die Energien der durch die Erwärmung der Oberfläche 211 des Elektronenkonverters 207 erzeugten Wärmestrahlung mit Photonenenergien von beispielsweise 1 meV bis 500 meV.

Die Abbildung der durch die Schicht 271 aus Szintillatormaterial erzeugten Photonen auf den Lichtdetektor 237 erzeugt dort ein Bild, welches die Verteilung der auf die Oberfläche 211 des Elektronenkonverters 207 auftreffenden Elektronenintensitäten repräsentiert. Diese Bilder können wieder an die Steuerung 235 ausgelesen werden und dazu verwendet werden, die durch die Detektionselemente 215 des ersten Detektionssystems 213 detektierten Signale den einzelnen Elektronenstrahlen 9 und schließlich den Auftrefforten der Teilchenstrahlen 3 auf das Objekt 7 zuzuordnen.

**Patentansprüche**

1. Verfahren zum Betreiben eines Vielstrahl-Teilchenstrahlmikroskops (1), wobei das Verfahren umfasst:

   Scannen einer Vielzahl von Teilchenstrahlen (3) über ein Objekt (7);
   Richten von von Auftrefforten (5) der Teilchenstrahlen an dem Objekt ausgehenden Elektronenstrahlen (9) auf einen Elektronenkonverter (207);
   Detektieren von in dem Elektronenkonverter durch auftreffende Elektronen erzeugten ersten Signalen mit einer Mehrzahl von Detektionselementen (215) eines ersten Detektionssystems (213) während eines ersten Zeitraums; und
   Detektieren von in dem Elektronenkonverter durch auftreffende Elektronen erzeugten zweiten Signalen mit einer Mehrzahl von Detektionselementen (219) eines zweiten Detektionssystems (218) während eines zweiten Zeitraums, wobei eine Anzahl der Detektionselemente des zweiten Detektionssystems mehr als doppelt so groß ist wie eine Anzahl der Detektionselemente des ersten Detektionssystems;
   **gekennzeichnet durch**
   Zuordnen der Signale, welche während des ersten Zeitraums mit den Detektionselementen des ersten Detektionssystems detektiert wurden, zu den Auftrefforten, und zwar basierend auf den Detektionssignalen, welche während des zweiten Zeitraums mit den Detektionselementen des zweiten Detektionssystems detektiert wurden.

2. Verfahren nach Anspruch 1,

   wobei das Detektieren der in dem Elektronenkonverter durch die auftreffenden Elektronen erzeugten ersten Signalen mit der Mehrzahl von Detektionselementen des ersten Detektionssystems mit einer Rate erfolgt, die größer ist als eine Grenzfrequenz, und
   wobei das Detektieren der in dem Elektronenkonverter durch die auftreffenden Elektronen erzeugten zweiten Signalen mit der Mehrzahl von Detektionselementen des zweiten Detektionssystems mit einer Rate erfolgt, die kleiner ist ein 0,5-faches der Grenzfrequenz ist.

3. Verfahren nach einem der Anspruch 1 oder 2,
   wobei die Detektionssignale, welche während des ersten Zeitraums mit einem einzigen Detektionselement der Detektionselemente des ersten Detektionssystems detektiert wurden, wenigstens zwei verschiedenen Auftrefforten zugeordnet werden.

4. Verfahren nach einem der Ansprüche 1 bis 3, ferner umfassend:

   Zuordnen der Detektionssignale, welche während des ersten Zeitraums mit einem jeden Detektionselement der Detektionselemente des ersten Detektionssystems aufgenommen wurden, zu einem oder mehreren Teilchenstrahlen der Vielzahl von Teilchenstrahlen,
   wobei die Detektionssignale, die einem gleichen der Vielzahl von Teilchenstrahlen zugeordnet werden, einem gleichen Auftreffort zugeordnet werden.

5. Verfahren nach einem der Ansprüche 1 bis 4,

   wobei das Scannen der Vielzahl der Teilchenstrahlen ein Ablenken der Teilchenstrahlen basierend auf einem sich zeitlich ändernden Ablenksignal erfolgt; und
   wobei das Zuordnen der Detektionssignale, welche während des ersten Zeitraums mit den Detektionselementen des ersten Detektionssystems detektiert wurden, zu den Auftrefforten ferner basierend auf dem Ablenksignal erfolgt.

6. Verfahren nach einem der Ansprüche 1 bis 5,

   wobei die Anzahl der Detektionselemente des ersten Detektionssystems größer ist als eine Anzahl der Vielzahl von Teilchenstrahlen, und/oder
   wobei die Anzahl der Detektionselemente des ersten Detektionssystems gleich einem ganzzahligen Vielfachen der Anzahl der Vielzahl von Teilchenstrahlen ist, und/oder
   wobei die Anzahl der Detektionselemente des ersten Detektionssystems gleich der Anzahl der Vielzahl von Teilchenstrahlen ist.

7. Verfahren nach einem der Ansprüche 1 bis 6,
wobei die in dem Elektronenkonverter erzeugten ersten Signale Photonen sind.

8. Verfahren nach einem der Ansprüche 1 bis 7,

   wobei die Detektionselemente des ersten Detektionssystems Photomultiplier und/oder Avalanche-Photodioden umfassen; und/oder
   wobei die in dem Elektronenkonverter erzeugten ersten Signale elektrische Signale sind.

9. Verfahren nach einem der Ansprüche 1 bis 8,

   wobei die in dem Elektronenkonverter erzeugten zweiten Signale Photonen sind,
   wobei die Detektionselemente des zweiten Detektionssystems in einem Feld nebeneinander angeordnet sind, und
   wobei das Verfahren ferner ein optisches Abbilden einer Oberfläche des Elektronenkonverters auf das Feld von Detektionselementen des zweiten Detektionssystems umfasst.

10. Verfahren nach Anspruch 9,
ferner umfassend Verwenden von Photonen für das optische Abbilden, welche aus dem Elektronenkonverter an einer Seite austreten, auf welcher die Elektronenstrahlen auf den Elektronenkonverter auftreffen.

11. Verfahren nach Anspruch 10,
wobei die von den Detektionselementen des zweiten Detektionssystems detektierten Photonen eine Energie von 1 meV bis 500 meV aufweisen.

12. Verfahren nach einem der Ansprüche 9 bis 11,
wobei die Detektionselemente des zweiten Detektionssystems Fotodioden umfassen, wobei das zweite Detektionssystem insbesondere eine CCD umfasst.

13. Vielstrahl-Teilchenstrahlsystem, umfassend:

   einen Elektronenkonverter (207);
   ein Beleuchtungssystem (300), welches dazu konfiguriert ist, ein Feld von Auftrefforten (5) an einem Objekt (7) mit einer Vielzahl von Teilchenstrahlen (3) zu beleuchten;
   ein Projektionssystem (102, 205), welches dazu konfiguriert ist, von den Auftrefforten ausgehende Elektronenstrahlen (9) auf den Elektronenkonverter zu richten;
   ein erstes Detektionssystem (213) mit einer Mehrzahl von Detektionselementen (215), welche dazu konfiguriert sind, in dem Elektronenkonverter durch auftreffende Elektronen erzeugte erste Signale zu detektieren;
   ein zweites Detektionssystem (218) mit einer Mehrzahl von Detektionselementen (219), welche in einem Feld nebeneinander angeordnet und dazu konfiguriert sind, in dem Elektronenkonverter durch auftreffende Elektronen erzeugte zweite Signale zu detektieren, wobei die zweiten Signale Photonen sind; und
   ein optisches Abbildungssystem (221), welches dazu konfiguriert ist, eine Fläche des Elektronenkonverters optisch auf das Feld von Detektionselementen des zweiten Detektionssystems abzubilden;
   **dadurch gekennzeichnet, dass** durch das optische Abbildungssystem solche Photonen auf die Detektionselementen des zweiten Detektionssystems gerichtet werden, die aus der Fläche des Elektronenkonverters austreten, auf welche auch die Elektronenstrahlen auf den Elektronenkonverter gerichtet sind.

14. Vielstrahl-Teilchenstrahlsystem nach Anspruch 13,
wobei der Elektronenkonverter ein Szintillatormaterial umfasst, welches Energie der Elektronenstrahlen in Photonen umwandelt.

**Claims**

1. Method for operating a multi-beam particle beam microscope (1),
wherein the method comprises:

   scanning a multiplicity of particle beams (3) over an object (7);

directing electron beams (9) emanating from impingement locations (5) of the particle beams at the object onto an electron converter (207);

detecting first signals generated by impinging electrons in the electron converter by means of a plurality of detection elements (215) of a first detection system (213) during a first time period; and

detecting second signals generated by impinging electrons in the electron converter by means of a plurality of detection elements (219) of a second detection system (218) during a second time period, wherein a number of the detection elements of the second detection system is more than double the magnitude of a number of the detection elements of the first detection system;

**characterized by**

assigning to the impingement locations the signals which were detected by means of the detection elements of the first detection system during the first time period, specifically on the basis of the detection signals which were detected by means of the detection elements of the second detection system during the second time period.

2. Method according to Claim 1,

wherein detecting the first signals generated by the impinging electrons in the electron converter by means of the plurality of detection elements of the first detection system is carried out at a rate that is greater than a limit frequency, and

wherein detecting the second signals generated by the impinging electrons in the electron converter by means of the plurality of detection elements of the second detection system is carried out at a rate that is less than 0.5 times the limit frequency.

3. Method according to either of Claims 1 and 2,
wherein the detection signals which were detected by means of a single detection element of the detection elements of the first detection system during the first time period are assigned to at least two different impingement locations.

4. Method according to any of Claims 1 to 3, furthermore comprising:

assigning the detection signals which were recorded by means of each detection element of the detection elements of the first detection system during the first time period to one or a plurality of particle beams of the multiplicity of particle beams,

wherein the detection signals which are assigned to an identical one of the multiplicity of particle beams are assigned to an identical impingement location.

5. Method according to any of Claims 1 to 4,

wherein scanning the multiplicity of particle beams comprises deflecting the particle beams on the basis of a deflection signal that changes over time; and

wherein assigning to the impingement locations the detection signals which were detected by means of the detection elements of the first detection system during the first time period is furthermore carried out on the basis of the deflection signal.

6. Method according to any of Claims 1 to 5,

wherein the number of the detection elements of the first detection system is greater than a number of the multiplicity of particle beams, and/or

wherein the number of the detection elements of the first detection system is equal to an integral multiple of the number of the multiplicity of particle beams, and/or

wherein the number of the detection elements of the first detection system is equal to the number of the multiplicity of particle beams.

7. Method according to any of Claims 1 to 6,
wherein the first signals generated in the electron converter are photons.

8. Method according to any of Claims 1 to 7,

wherein the detection elements of the first detection system comprise photomultipliers and/or avalanche photodiodes; and/or

EP 3 857 588 B1

wherein the first signals generated in the electron converter are electrical signals.

9. Method according to any of Claims 1 to 8,

wherein the second signals generated in the electron converter are photons, wherein the detection elements of the second detection system are arranged next to one another in an array, and
wherein the method furthermore comprises optically imaging a surface of the electron converter onto the array of detection elements of the second detection system.

10. Method according to Claim 9,
furthermore comprising using photons for the optical imaging which emerge from the electron converter at a side on which the electron beams impinge on the electron converter.

11. Method according to Claim 10,
wherein the photons detected by the detection elements of the second detection system have an energy of 1 meV to 500 meV.

12. Method according to any of Claims 9 to 11,
wherein the detection elements of the second detection system comprise photodiodes, wherein the second detection system comprises a CCD, in particular.

13. Multi-beam particle beam system, comprising:

an electron converter (207);
an illumination system (300) configured to illuminate an array of impingement locations (5) at an object (7) with a multiplicity of particle beams (3);
a projection system (102, 205) configured to direct electron beams (9) emanating from the impingement locations onto the electron converter;
a first detection system (213) having a plurality of detection elements (215) configured to detect first signals generated by impinging electrons in the electron converter;
a second detection system (218) having a plurality of detection elements (219) arranged next to one another in an array and configured to detect second signals generated by impinging electrons in the electron converter, wherein the second signals are photons; and
an optical imaging system (221) configured to image a surface of the electron converter optically onto the array of detection elements of the second detection system;
**characterized in that** such photons which emerge from that surface of the electron converter onto which the electron beams are also directed onto the electron converter are directed onto the detection elements of the second detection system by the optical imaging system.

14. Multi-beam particle beam system according to Claim 13,
wherein the electron converter comprises a scintillator material which converts energy of the electron beams into photons.

**Revendications**

1. Procédé pour faire fonctionner un microscope (1) à faisceaux de particules à faisceaux multiples,
dans lequel le procédé comprend les étapes suivantes :

opérer un balayage d'un un objet (7) par une pluralité de faisceaux de particules (3) ;
diriger des faisceaux d'électrons (9) provenant des points d'impact (5) des faisceaux de particules sur l'objet vers un convertisseur d'électrons (207) ;
détecter les premiers signaux générés dans le convertisseur d'électrons par les électrons incidents au moyen d'une pluralité d'éléments de détection (215) d'un premier système de détection (213) pendant une période de temps prédéterminée ; et
détecter les deuxièmes signaux générés dans le convertisseur d'électrons par les électrons incidents au moyen d'une pluralité d'éléments de détection (219) d'un deuxième système de détection (218) pendant une deuxième période de temps,

15

un nombre d'éléments de détection du deuxième système de détection étant au plus deux fois plus grand qu'un nombre d'éléments de détection du premier système de détection ;
**caractérisé par**
le fait d'associer aux emplacements d'impact les signaux détectés au cours de la première période au moyen des éléments de détection du premier système de détection, sur la base des signaux de détection détectés au cours de la deuxième période au moyen des éléments de détection du deuxième système de détection.

2. Procédé selon la revendication 1,

   dans lequel la détection, au moyen de la pluralité d'éléments de détection du premier système de détection, des premiers signaux générés dans le convertisseur d'électrons par les électrons incidents s'effectue à une fréquence supérieure à une fréquence limite, et
   dans lequel la détection, au moyen de la pluralité d'éléments de détection du deuxième système de détection, des deuxièmes signaux générés dans le convertisseur d'électrons par les électrons incidents est effectuée à une fréquence inférieure à 0,5 fois la fréquence limite.

3. Procédé selon l'une des revendications 1 ou 2,
   dans lequel les signaux de détection qui ont été détectés pendant la première période avec un seul élément de détection parmi les éléments de détection du premier système de détection sont associés à au moins deux emplacements d'impact différents.

4. Procédé selon l'une des revendications 1 à 3, comprenant en outre :

   le fait d'associer les signaux de détection, qui ont été enregistrés pendant la première période au moyen de chaque élément de détection des éléments de détection du premier système de détection, à un ou plusieurs faisceaux de particules de la pluralité de faisceaux de particules,
   les signaux de détection qui sont associés à un même faisceau de la pluralité de faisceaux de particules étant associés à un même point d'impact.

5. Procédé selon l'une des revendications 1 à 4,

   dans lequel le balayage de la pluralité de faisceaux de particules est effectué en déviant les faisceaux de particules sur la base d'un signal de déviation variant dans le temps ; et
   l'association des signaux de détection, qui ont été détectés pendant la première période au moyen des éléments de détection du premier système de détection, aux points d'impact s'effectue en outre sur la base du signal de déviation.

6. Procédé selon l'une des revendications 1 à 5,

   dans lequel le nombre d'éléments de détection du premier système de détection est supérieur au nombre de la pluralité de faisceaux de particules, et/ou
   dans lequel le nombre d'éléments de détection du premier système de détection est égal à un multiple entier du nombre de la pluralité de faisceaux de particules, et/ou
   dans lequel le nombre d'éléments de détection du premier système de détection est égal au nombre de la pluralité de faisceaux de particules.

7. Procédé selon l'une des revendications 1 à 6,
   dans lequel les premiers signaux générés dans le convertisseur d'électrons sont des photons.

8. Procédé selon l'une des revendications 1 à 7,

   dans lequel les éléments de détection du premier système de détection comprennent des photomultiplicateurs et/ou des photodiodes à avalanche ; et/ou
   dans lequel les premiers signaux générés dans le convertisseur d'électrons sont des signaux électriques.

9. Procédé selon l'une des revendications 1 à 8,

   dans lequel les deuxièmes signaux générés dans le convertisseur d'électrons sont des photons,

dans lequel les éléments de détection du deuxième système de détection sont agencés les uns à côté des autres dans un champ, et

le procédé comprenant en outre la formation d'une image optique d'une surface du convertisseur d'électrons sur le champ d'éléments de détection du deuxième système de détection.

10. Procédé selon la revendication 9,
comprenant en outre le fait d'utiliser des photons pour la formation d'image optique, qui sortent du convertisseur d'électrons d'un côté sur lequel les faisceaux d'électrons frappent le convertisseur d'électrons.

11. Procédé selon la revendication 10,
dans lequel les photons détectés par les éléments de détection du deuxième système de détection comprennent une énergie allant de 1meV à 500meV.

12. Procédé selon l'une des revendications 9 à 11,
dans lequel les éléments de détection du deuxième système de détection comprennent des photodiodes, le deuxième système de détection comprenant en particulier un dispositif à liaison de charge (CCD).

13. Système de faisceaux de particules à faisceaux multiples, comprenant :

un convertisseur d'électrons (207) ;
un système d'éclairage (300) configuré pour éclairer un champ de points d'impact (5) sur un objet (7) avec une pluralité de faisceaux de particules (3) ;
un système de projection (102, 205) configuré pour diriger des faisceaux d'électrons (9) provenant des points d'impact sur le convertisseur d'électrons ;
un premier système de détection (213) comprenant une pluralité d'éléments de détection (215) qui sont configurés pour détecter des premiers signaux générés dans le convertisseur d'électrons par des électrons incidents ;
un deuxième système de détection (218) comprenant une pluralité d'éléments de détection (219) qui sont agencés côte à côte dans un champ et configurés pour détecter des deuxièmes signaux générés dans le convertisseur d'électrons par des électrons incidents, les deuxièmes signaux étant des photons ; et
un système optique de formation d'image (221) qui est configuré pour former optiquement une image d'une surface du convertisseur d'électrons sur le champ d'éléments de détection du deuxième système de détection ;
**caractérisé en ce que** le système de formation d'image optique dirige sur les éléments de détection du deuxième système de détection les photons qui sortent de la surface du convertisseur d'électrons sur laquelle les faisceaux d'électrons sont également dirigés.

14. Système de faisceau de particules à faisceaux multiples selon la revendication 13,
dans lequel le convertisseur d'électrons comprend un matériau scintillateur qui convertit l'énergie des faisceaux d'électrons en photons.

FIG. 1

209

221

225

223    223    213

215

9    207

218

219

## Fig. 2

213

229    227

211    227

231    227

229    233

227

235

## Fig. 3

Fig. 4

Fig. 5

Fig 6

```
                    ┌─────────────────┐
                    │   Bildanalyse   │  ⌇ 253
                    └─────────────────┘
```

253

Bildanalyse

257

| I1 | | I'1 | | I"(1i,1i) |
| I2 | | I'2 | | I"(2i,2i) |
| I3 | | I'3 | | I"(3i,3i) |
| I4 | | I'4 | | I"(4i,4i) |
| I5 | | I'5 | | I"(5i,5i) |
| I6 | | I'6 | | I"(6i,6i) |
| . | | . | | . |
| . | | . | | . |
| . | | . | | . |
| I25 | | I'25 | | I"(25i,25i) |

251          255          261

Scansignal

259

Fig 7

Fig. 8

| Detektieren von 25 Signalen mit Fotomultipier | 25 x | Detektieren von 4096 Signalen mit CCD Detektor | 1 x | 9 x |

Fig 9

Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20150083911 A1
- WO 2018172186 A1
- WO 2005024881 A2
- WO 2007028595 A2
- WO 2007028596 A1
- WO 2007060017 A2
- WO 2016124648 A1